(19) Europäisches Patentamt / European Patent Office / Office européen des brevets

(11) **EP 1 388 935 B1**

(12) **FASCICULE DE BREVET EUROPEEN**

(45) Date de publication et mention
de la délivrance du brevet:
**19.11.2008 Bulletin 2008/47**

(51) Int Cl.:
***H03F 3/60*** (2006.01)

(21) Numéro de dépôt: **03291819.5**

(22) Date de dépôt: **23.07.2003**

(54) **Dispositif de charge active permettant de polariser un circuit amplificateur distribué très large bande avec contrôle de gain**

Aktive Lastvorrichtung zum Einstellen einer Ultrabreitbandkettenverstärkerschaltung mit Verstärkungsregelung

Active load device for biasing an ultra wideband distributed amplifier with gain control

(84) Etats contractants désignés:
**AT BE BG CH CY CZ DE DK EE ES FI FR GB GR HU IE IT LI LU MC NL PT RO SE SI SK TR**

(30) Priorité: **23.07.2002 FR 0209335**

(43) Date de publication de la demande:
**11.02.2004 Bulletin 2004/07**

(73) Titulaire: **Vectrawave**
**78350 Les Loges en Josas (FR)**

(72) Inventeurs:
• **Claveau, Régis**
**22560 Trebeurden (FR)**
• **Soares, Robert**
**22700 Perros Guirec (FR)**
• **Boumard, Benoît**
**22300 Lannion (FR)**
• **Chelouah, Abdenour**
**22300 Lannion (FR)**

(74) Mandataire: **Callon de Lamarck, Jean-Robert et al**
**Cabinet Regimbeau**
**20 rue de Chazelles**
**75847 Paris cedex 17 (FR)**

(56) Documents cités:
**US-A- 5 196 805     US-A- 5 880 640**

• **VERSNAEYEN C ET AL: "REALISATION DE MACRO COMPOSANTS HYPERFREQUENCES EN TECHNOLOGIE MONOLITHIQUE" REVUE DE PHYSIQUE APPLIQUEE, LES EDITIONS DE PHYSIQUE. PARIS, FR, vol. 23, no. 7, 1 juillet 1988 (1988-07-01), pages 1215-1220, XP000022894**

**Description**

L'invention concerne le domaine des amplificateurs, notamment des amplificateurs intégrés MMIC(Circuit Intégré Monolithique Hyperfréquence) et plus particulièrement les amplificateurs distribués.

Ces circuits permettent d'amplifier des signaux sur une très large bande de fréquence (du continu à 100 GHz) et sont généralement utilisés dans des applications de télécommunications optiques.

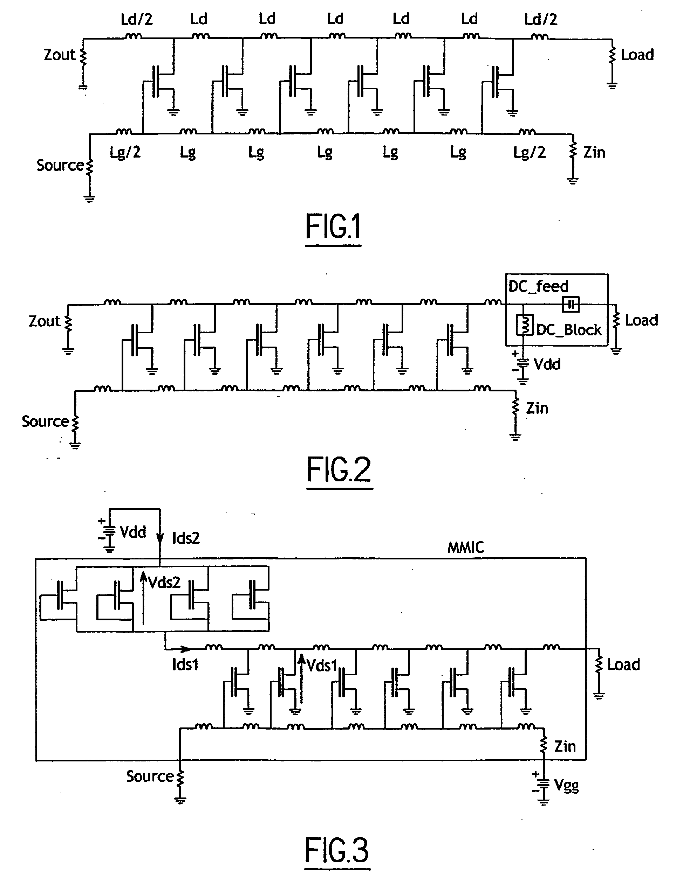

La figure 1 représente un exemple d'amplificateur distribué. Un tel amplificateur comprend une succession de cellules amplificatrices connectées entre deux lignes de transmission. L'une (ligne de grille) est reliée à son extrémité à une impédance d'entrée Zin (terminaison), l'autre (ligne de drain) est reliée à son extrémité à une impédance de sortie Zout (terminaison).

Les amplificateurs distribués présentent l'avantage de contourner les limitations en fréquence des amplificateurs classiques. Pour une adaptation idéale des lignes d'entrée et de sortie, les impédances de terminaison, respectivement Zin et Zout, doivent avoir la même valeur que l'impédance caractéristique de leurs lignes respectives.

L'un des problèmes posés par ces amplificateurs distribués concerne leur polarisation en tension et en courant continu. Ainsi qu'illustré sur la figure 2, la tension de polarisation et le courant continu associé peuvent être amenés par un circuit de polarisation réalisé à l'extérieur du circuit intégré MMIC.

Le circuit de polarisation comprend une série de self-inductances connectées à une source de tension pour amener la tension et le courant continus sur la ligne de drain de l'amplificateur distribué.

Dans ce cas l'amplificateur est polarisé par la voie de sortie radiofréquence (RF).

La principale difficulté est la réalisation d'un tel dispositif sur une très large bande de fréquences (20KHz à 100GHz) avec des contraintes de courant élevé, de faibles pertes RF et de bons coefficients de réflexion.

En outre, le circuit de polarisation est encombrant, ce qui pose problème pour son intégration dans des boîtiers de faibles dimensions nécessaires pour la montée en fréquence.

Pour pallier ces inconvénients, une solution consiste à polariser l'amplificateur distribué à travers la terminaison de la ligne de sortie, Zout. Cette solution permet à la fois d'assurer les besoins d'une bonne terminaison de cette ligne et de polariser correctement l'amplificateur.

Toutefois, pour des applications demandant une forte puissance de sortie, l'amplificateur distribué exige une tension de polarisation élevée et un courant continu important. Polariser l'amplificateur à travers la terminaison résistive Zout amène, dans le cas de ces applications, une forte chute de tension aux bornes de la résistance et fait apparaître des problèmes de dissipation thermique.

De plus le dimensionnement de la résistance de charge apporte une capacité parasite importante.

Cette solution n'est donc viable qu'à condition d'accepter une dégradation des performances de l'amplificateur.

Pour s'affranchir de ces difficultés, une autre solution consiste à utiliser une charge active composée de charges saturables (transistors à effet de champs avec leur tension drain-source saturée) pour réaliser la terminaison Zout.

La figure 3 représente un amplificateur distribué comprenant une telle charge active. La charge active est composée d'un ensemble de transistors connectés en parallèle entre une source de tension $V_{DD}$ et la ligne de drain de l'amplificateur distribué. Chaque transistor a sa grille connectée à sa source. Cette charge active permet de polariser l'amplificateur distribué et d'obtenir une terminaison de ligne satisfaisante en évitant les inconvénients liés à la polarisation à travers une charge résistive.

La charge active est calculée pour satisfaire les conditions suivantes :

$$V_{DS1} + V_{DS2} = V_{DD}$$

$$I_{DS1} = I_{DS2}$$

$$Zca \approx Zout \text{ pour } V_{DS2} > V_{DSsat}$$

où $V_{DS1}$ est la tension drain-source de la cellule d'amplification, $V_{DS2}$ est la tension drain-source de la charge active, $V_{DD}$ est la tension d'alimentation, $I_{DS1}$ est le courant délivré à la cellule d'amplification, $I_{DS2}$ est le courant fourni par la charge active, Zca est l'impédance de la charge active et $V_{DSsat}$ est la tension de saturation drain-source des transistors de la charge active.

Un inconvénient de cette solution est que la charge active ne permet pas d'obtenir une impédance Zout stable si le courant continu $I_{DS1}$ (=$I_{DS2}$) varie, dans le cas d'un contrôle de gain par exemple.

Lorsque le courant $I_{DS1}$ diminue, les transistors constituant la charge active peuvent sortir de leur zone saturée de fonctionnement et opérer dans leur zone linéaire. Il en résulte :

- que l'impédance de la charge active devient faible et la condition Zca = Zout n'est plus respectée,
- que la polarisation continue de l'amplificateur distribué est modifiée.

Le document US 5 880 640 concerne un amplificateur comprenant une pluralités de cellules amplificatrices montées en série, avec une ligne de drain commune et une ligne de grille commune, chaque cellule comportant un transistor à effet de champ monté en source commune. L'amplificateur comprend un circuit de polarisation de la ligne de drain, le circuit de polarisation incluant des moyens de filtrage sous forme d'une pluralité de transistors à effet de champ fonctionnant en charge saturable. Les sources des transistors sont connectées sur la ligne de drain et les drains des transistors reçoivent une tension de polarisation qui appliquée sur la ligne de drain commune. Ce document indique que cet amplificateur est particulièrement adapté pour être réalisé sous forme d'un circuit intégré monolithique.

Un but de l'invention est donc de fournir une charge active pour amplificateur distribué permettant de maintenir les conditions de polarisation de l'amplificateur et de conserver la condition Zca=Zout indépendamment du courant qui traverse la charge active.

A cet effet, l'invention propose un circuit amplificateur très large bande comprenant une cellule d'amplification distribuée connectée à une cellule de polarisation, la cellule d'amplification incluant plusieurs transistors connectés en parallèle entre une ligne de drain et une ligne de grille, terminées chacune à l'une de ses extrémités par une charge (Zin, Zout), la cellule de polarisation incluant au moins un transistor connecté entre une alimentation et la ligne de drain de la cellule d'amplification, ladite cellule de polarisation présentant une impédance globale égale à l'impédance de la charge (Zout) connectée à l'extrémité de la ligne de drain de la cellule d'amplification, caractérisé en ce que la grille du transistor de la cellule de polarisation est reliée au noeud d'un pont diviseur de manière à fixer son potentiel de grille, et en ce que la grille et la source dudit transistor sont reliées entre elles par l'intermédiaire d'au moins un condensateur.

Le fait de fixer le potentiel de grille de la charge active et de laisser le potentiel de sa source « flottant » permet d'assurer que la tension drain-source $V_{DS2}$ de la cellule de polarisation soit toujours supérieure à la tension de saturation des transistors de cette cellule quelque soit la valeur du courant $I_{DS1}$ traversant l'amplificateur. L'invention permet donc de garantir que ces transistors fonctionnent dans leur zone saturée.

D'autres caractéristiques et avantages ressortiront encore de la description qui suit, laquelle est purement illustrative et non-limitative et doit être lue en regard des figures annexées parmi lesquelles :

- la figure 1 déjà commentée représente un exemple de circuit amplificateur distribué,
- la figure 2 déjà commentée représente un exemple de circuit amplificateur comprenant un circuit de polarisation, conforme à un mode de réalisation de l'art antérieur,
- la figure 3 déjà commentée représente un exemple de circuit amplificateur comprenant une charge active, conforme à un autre mode de réalisation de l'art antérieur,
- la figure 4 représente un exemple de montage amplificateur comprenant une charge active, conforme à un mode de réalisation de l'invention,
- la figure 5 représente un circuit équivalent de la charge active du circuit de la figure 4,
- les figures 6 à 12 représentent des exemples de charges actives pouvant être utilisées dans le cadre de l'invention.

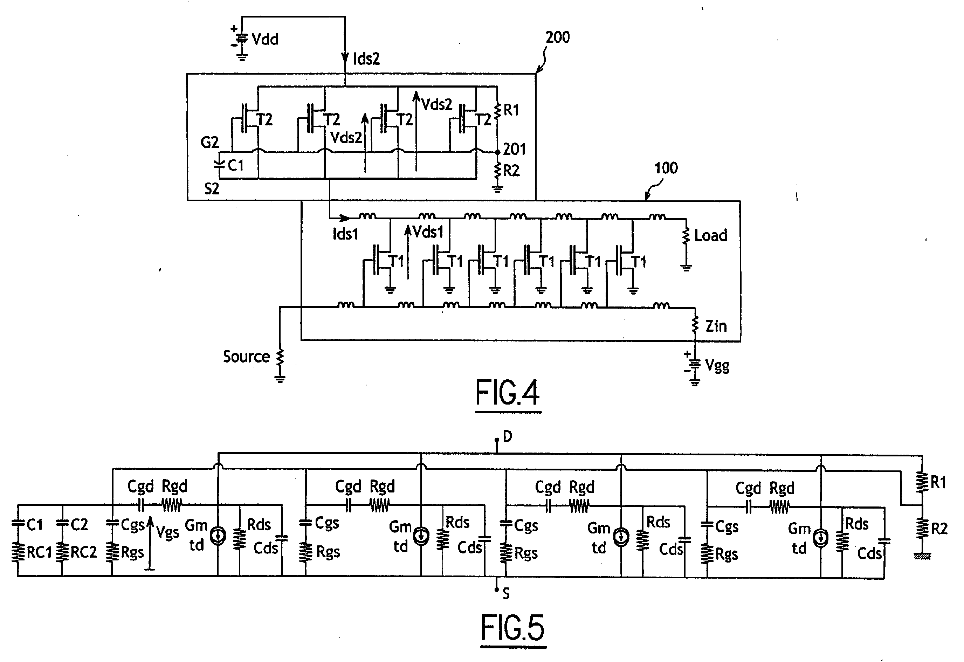

Sur la figure 4, le montage amplificateur comprend une cellule d'amplification 100 comprenant des transistors T1 connectés en parallèle entre une ligne de drain et une ligne de grille, ainsi qu'une cellule de polarisation 200 connectée entre une alimentation $V_{DD}$ et la ligne de drain de la cellule d'amplification 100.

La cellule de polarisation 200 comprend une pluralité de transistors T2 connectés en parallèle entre l'alimentation $V_{DD}$ et la ligne de drain de la cellule d'amplification 100. La cellule de polarisation comprend également un pont diviseur R1R2 connecté entre l'alimentation $V_{DD}$ et la masse et dont le noeud 201 est relié aux grilles des transistors T2. Ce pont diviseur permet de fixer les potentiels de grille des transistors T2 tandis que leur source S2 est laissée flottante.

Le montage de la figure 4 permet d'assurer que la condition $V_{DS2} > V_{DSsat}$ est respectée quelque soit la valeur du courant $I_{DS1} = I_{DS2}$. Dans un tel montage, une baisse du courant s'accompagne d'une contribution simultanée de $V_{GS2}$ et $V_{DS2}$. Le courant continu de polarisation est au départ fixé pour une condition de fonctionnement souhaité (par exemple pour obtenir un gain maximal), et le pont diviseur est calculé pour que les potentiels de grille et de source de la charge active soient égaux. Les valeurs des résistances R1 et R2 sont choisies pour minimiser le courant dans le pont.

Pour améliorer la performance du montage en basses fréquences, la partie réelle de l'impédance Zca de la charge active devenant trop faible, un condensateur C1, ayant une valeur de capacité (par exemple 150nF) permettant d'obtenir la fréquence de coupure basse recherchée (dans ce cas 20kHz), est connecté entre la grille G2 et la source S2 des transistors T2 de la cellule de polarisation. Ce condensateur peut être implanté physiquement en dehors du circuit intégré MMIC. A cet effet, il est relié par des fils de connexion aux noeuds G2 et S2 des transistors T2.

En pratique, la présence d'éléments parasites de connexion (fils de connexion et lignes) nécessite l'intégration d'au moins un condensateur C2 supplémentaire entre ces mêmes noeuds G2 et S2, au plus près des transistors de la charge active.

Les valeurs des éléments utilisés sont choisies pour que l'ensemble du dispositif maintient au mieux la condition Zca=Zout sur la gamme fréquences utilisée.

La figure 5 représente un schéma équivalent de la charge active de la figure 4 comprenant en plus le condensateur supplémentaire C1 et C2. Ce schéma équivalent est donné pour une charge active comprenant quatre transistors T2 à effet de champs ainsi que de deux condensateurs, l'un C2 sur la puce MMIC et l'autre C1 à l'extérieur. La charge active doit laisser passer le courant continu de polarisation $I_{DS2}$, (c'est-à-dire avoir une transconductance gm adéquate) et présenter une impédance $R_{DS}$ adaptée. Les valeurs des éléments équivalents dépendent du développement de grille W et de la polarisation du transistor (indice 0):

$$Rgs = \frac{Rgs_0}{W}$$

$$Rgd = \frac{Rgd_0}{W}$$

$$Rds = \frac{Rds_0}{W}$$

$$Cgs = Ggs_0 \times W$$

$$Cgd = Cgd_0 \times W$$

$$Cds = Cds_0 \times W$$

$$gm = gm_0 \times W$$

Du schéma équivalent de la figure 5, on extrait la formule de l'impédance Zca de la charge active :

$$Zca = \frac{V_{DS}}{I_{DS1}} = \frac{1}{\dfrac{4}{R_{DS}} + 4j\omega C_{DS} + \dfrac{1 + 4gm.Zgs}{Zds}}$$

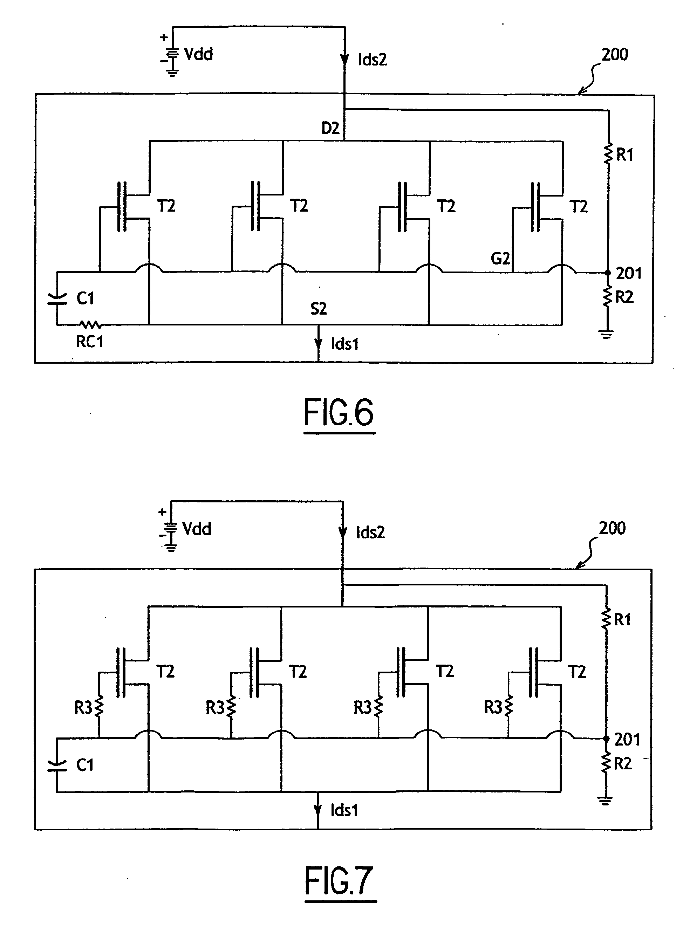

La figure 6 représente un autre exemple de cellule de polarisation similaire à celle du montage de la figure 4 mais dans laquelle une résistance $R_{C1}$ a été ajoutée en série avec le condensateur C1 entre la grille G2 et la source S2 de la charge active. Cette résistance joue un rôle d'amortissement. En outre, cette résistance modifie la valeur de l'impédance de la charge active et permet un meilleur comportement de la charge active en permettant de s'approcher au mieux de la condition Zca=Zout sur la gamme de fréquence utilisée.

La figure 7 représente un autre exemple de cellule de polarisation similaire à celle du montage de la figure 4 mais dans laquelle des résistances R3 ont été ajoutées, chacune de ces résistances R3 étant connectées entre la grille G2 d'un transistor T2 et le pont diviseur. Ces résistances R3 jouent un rôle d'amortissement pour éviter d'éventuels pics de résonance. Toutefois, cette configuration est généralement moins efficace que celle de la figure 6.

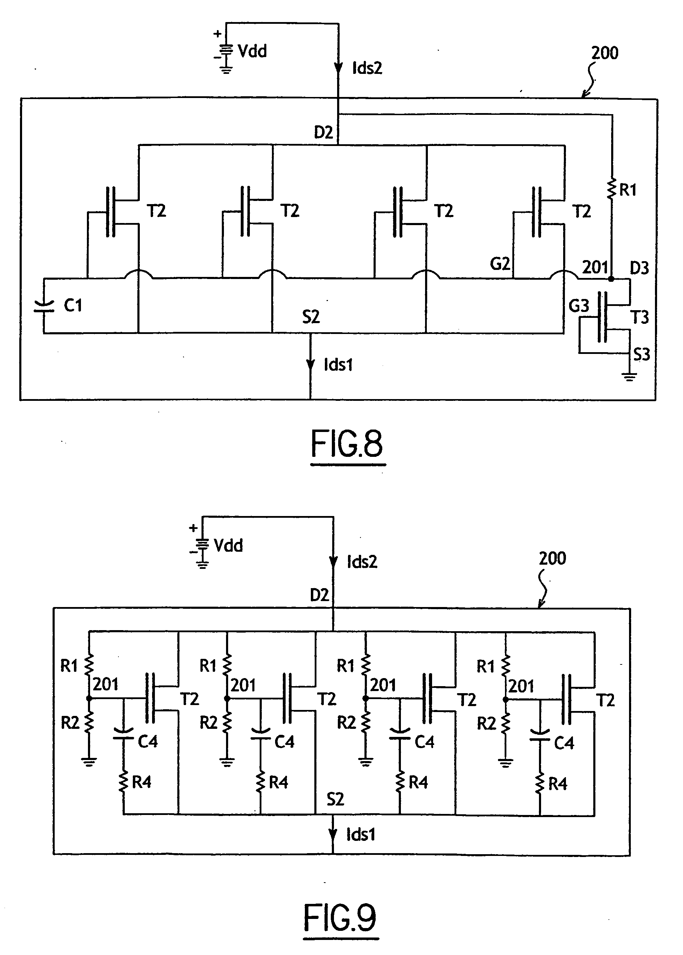

La figure 8 représente un autre exemple de cellule de polarisation similaire à celle du montage de la figure 4 mais dans laquelle la résistance R2 du pont diviseur a été remplacée par un transistor à effet de champ T3 ayant sa grille G3 et sa source S3 court-circuitées. Ce montage permet de réaliser la même valeur de résistance R2 en utilisant une structure plus compacte.

La figure 9 représente un exemple de cellule de polarisation dans lequel chaque transistor T2 de la charge active est relié par sa grille G2 à un pont diviseur R1R2. Un condensateur C4 en série avec une résistance R4 est connecté entre la grille G2 et la source S2 de chacun des transistors T2 de la charge active. Ce montage conduit à des circuits plus encombrant que les montages des figures 4 à 8, mais pourrait permettre de réaliser une charge plus constante dans la bande de fréquences utilisée et plus proche de la condition idéale Zca=Zout.

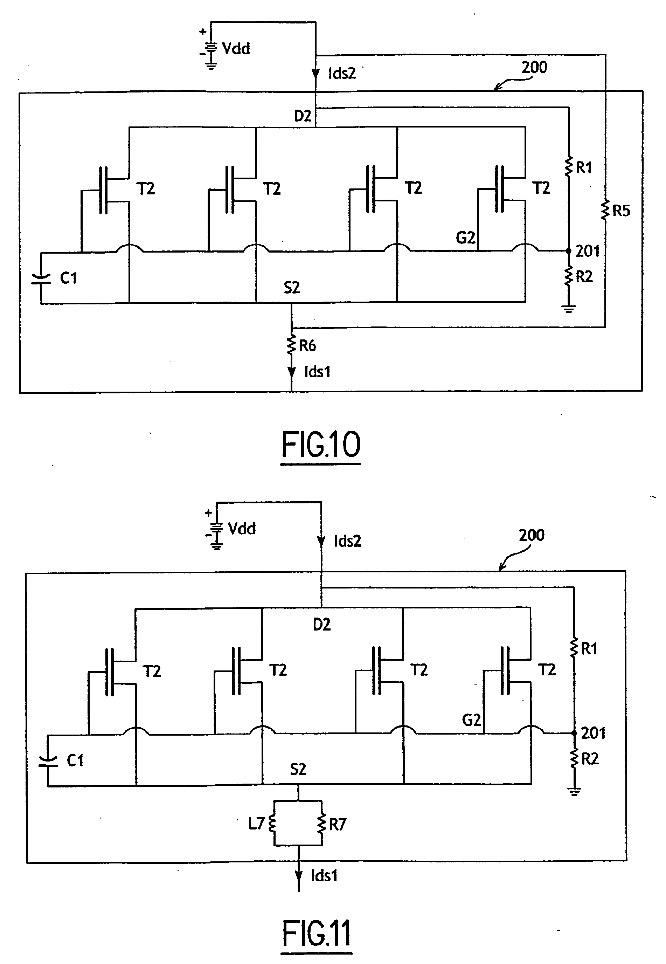

La figure 10 représente un autre exemple de cellule de polarisation similaire à celle du montage de la figure 4 mais comprenant une ou plusieurs résistances R5 montées en parallèle avec la charge active. De manière optionnelle, la cellule comprend également une ou plusieurs résistances R6 montées en série avec la charge active pour adapter l'impédance de la charge active. Le fait d'ajouter des résistances supplémentaires permet de se rapprocher des propriétés recherchées pour la cellule de polarisation à savoir, $I_{DS1}=I_{DS2}$ et Zca=Zout.

La figure 11 représente un autre exemple de cellule de polarisation similaire à celle du montage de la figure 4 mais comprenant une inductance L7 et une résistance R7 en parallèle. La résistance R7 et l'inductance L7 sont montées en série avec la charge active. Un tel montage permet d'augmenter la partie réelle de la charge active à hautes fréquences et donc de s'approcher des conditions $I_{DS1}=I_{DS2}$ et Zca=Zout.

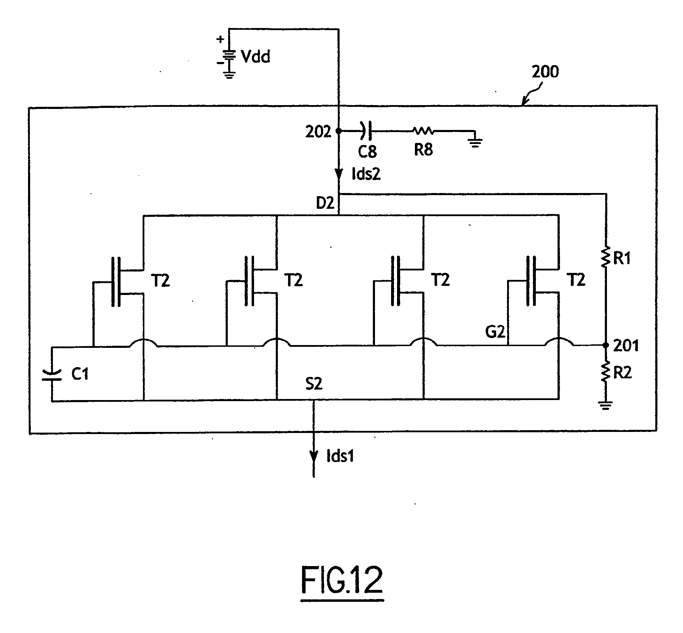

Enfin, la figure 12 représente un autre exemple de montage similaire à celle du montage de la figure 4 mais comprenant des résistances R8 en série avec des condensateurs C8 de découplage connectés entre le noeud 202 correspondant aux drains D2 des transistors T2 et la masse. Ce montage permet également d'augmenter la partie réelle de la charge active. Cette disposition peut être utilisée en combinaison avec le montage de la figure 11, ce qui améliore encore le résultat.

**Revendications**

1. Circuit amplificateur très large bande comprenant une cellule d'amplification distribuée (100) connectée à une cellule de polarisation (200), la cellule d'amplification (100) incluant plusieurs transistors (T1) connectés en parallèle entre une ligne de drain et une ligne de grille, terminées chacune à l'une de ses extrémités par une charge (Zin, Zout), la cellule de polarisation (200) incluant au moins un transistor (T2) connecté entre une alimentation ($V_{DD}$) et la ligne de drain de la cellule d'amplification (100), ladite cellule de polarisation présentant une impédance globale égale à l'impédance de la charge (Zout) connectée à l'extrémité de la ligne de drain de la cellule d'amplification (100), **caractérisé en ce que** la grille (G2) du transistor (T2) de la cellule de polarisation (200) est reliée au noeud (201) d'un pont diviseur (R1R2, R1T3) de manière à fixer son potentiel ($V_{G2}$) de grille (G2), et **en ce que** la grille (G2) et la source (S2) dudit transistor (T2) sont reliées entre elles par l'intermédiaire d'au moins un condensateur (C1, C2).

2. Circuit amplificateur selon la revendication 1, **caractérisé en ce qu'**il comprend une résistance (R) montée en série avec le condensateur (C) entre la grille (G2) et la source (S2) du transistor (T2) de la cellule (200) de polarisation.

3. Circuit amplificateur selon l'une des revendications qui précèdent, **caractérisé en ce qu'**il comprend une résistance (R3) connectée entre la grille (G2) du transistor (T2) et le noeud (201) du pont diviseur (R1R2, R1T3).

4. Circuit amplificateur selon l'une des revendications qui précèdent, **caractérisé en ce que** le pont diviseur (R1T3) comprend au moins un transistor (T3).

5. Circuit amplificateur selon l'une des revendications qui précèdent, **caractérisé en ce que** la cellule de polarisation (200) comprend plusieurs transistors (T2) en parallèle et plusieurs pont diviseurs (R1 R2) en parallèle et **en ce que** chacun desdits transistors (T2) est relié par sa grille (G2) à l'un des ponts diviseurs (R1R2).

6. Circuit amplificateur selon l'une des revendications qui précèdent, **caractérisé en ce qu'**il comprend au moins une résistance (R5) montée en parallèle avec la cellule de polarisation (200).

7. Circuit amplificateur selon l'une des revendications qui précèdent, **caractérisé en ce qu'**il comprend au moins une résistance (R6) montée en série avec la cellule de polarisation (200).

8. Circuit amplificateur selon l'une des revendications qui précèdent, **caractérisé en ce qu'**il comprend une inductance (L7) et une résistance (R7) en parallèle, montées en série avec la cellule de polarisation (200).

9. Circuit amplificateur selon l'une des revendications qui précèdent, **caractérisé en ce qu'**il comprend au moins une résistance (R8) et un condensateur (C8) en série, connectés entre le drain (D2) du transistor (T2) et la masse.

## Claims

1. Very wide band amplifier circuit including a distributed amplification cell (100) connected to a biasing cell (200), the amplification cell (100) including several transistors (T1) connected in parallel between a drain line and a grid line, each terminated at one of its ends by a load (Zin, Zout), the biasing cell (200) including at least one transistor (T2) connected between a power source ($V_{DD}$) and the drain line of the amplification cell (100), said biasing cell having an overall impedance equal to the impedance of the load (Zout) connected to the end of the drain line of the amplification cell (100), **characterised in that** the grid (G2) of the transistor (T2) of the biasing cell (200) is connected to the node (201) of a divider bridge (R1R2, R1T3) so as to set its grid (G2) potential ($V_{G2}$), and **in that** the grid (G2) and the source (S2) of said transistor (T2) are connected together by means of at least one capacitor (C1, C2).

2. Amplifier circuit as claimed in claim 1, **characterised in that** it includes a resistor (R) mounted in series with the capacitor (C) between the grid (G2) and the source (S2) of the transistor (T2) of the biasing cell (200).

3. Amplifier circuit as claimed in one of the preceding claims, **characterised in that** it includes a resistor (R3) connected between the grid (G2) of the transistor (T2) and the node (201) of the divider bridge (R1R2, R1T3).

4. Amplifier circuit as claimed in one of the preceding claims, **characterised in that** the divider bridge (R1T3) includes at least one transistor (T3).

5. Amplifier circuit as claimed in one of the preceding claims, **characterised in that** the biasing cell (200) includes several transistors (T2) arranged in parallel and several divider bridges (R1R2) arranged in parallel and **in that** each of said transistors (T2) is connected by its grid (G2) to one of the divider bridges (R1R2).

6. Amplifier circuit as claimed in one of the preceding claims, **characterised in that** it includes at least one resistor (R5) mounted in parallel with the biasing cell (200).

7. Amplifier circuit as claimed in one of the preceding claims, **characterised in that** it includes at least one resistor (R6) mounted in series with the biasing cell (200).

8. Amplifier circuit as claimed in one of the preceding claims, **characterised in that** it includes an inductor (L7) and a resistor (R7) arranged in parallel, mounted in series with the biasing cell (200).

9. Amplifier circuit as claimed in one of the preceding claims, **characterised in that** it includes at least one resistor (R8) and one capacitor (C8) arranged in series, connected between the drain (D2) of the transistor (T2) and the ground.

## Patentansprüche

1. Ultrabreitbandverstärkerschaltung bestehend aus einer verketteten Verstärkerzelle (100), welche an eine Polarisationszelle (200) angeschlossen ist, wobei die Verstärkerzelle (100) mehrere Transistoren (T1) umfasst, die in Parallelschaltung zwischen einer Drain-Leitung und einer Gate-Leitung angeschlossen sind, welche jeweils an einem ihrer Enden eine Last (Zin, Zout) aufweisen, wobei die Polarisationszelle (200) mindestens einen Transistor (T2) umfasst, der zwischen einer Speisung ($V_{DD}$) und der Drain-Leitung der Verstärkerzelle (100) angeschlossen ist, wobei besagte Polarisationszelle eine Gesamtimpedanz von gleich der Impedanz der Last (Zout) aufweist, welche an das Ende der Drain-Leitung der Verstärkerzelle (100) angeschlossen ist, **dadurch gekennzeichnet, dass** das Gate (G2) des Transistors (T2) der Polarisationszelle (200) so mit dem Anschluss (201) eines Spannungsteilers (R1R2, R1T3) verbunden ist, dass sein Potential ($V_{G2}$) des Gates (G2) fest ist, und **dadurch**, dass das Gate (G2) und die Source (S2) des besagten Transistors (T2) über mindestens einen Kondensator (C1, C2) miteinander verbunden sind.

2. Verstärkerschaltung nach Anspruch 1, **dadurch gekennzeichnet, dass** diese einen Widerstand (R) umfasst, der mit dem Kondensator (C) zwischen dem Gate (G2) und der Source (S2) des Transistors (T2) der Polarisationszelle (200) in Reihe geschaltet ist.

**3.** Verstärkerschaltung nach einem der vorstehenden Ansprüche, **dadurch gekennzeichnet, dass** diese einen Widerstand (R3) umfasst, der zwischen das Gate (G2) des Transistors (T2) und den Anschluss (201) des Spannungsteilers (R1R2, R1T3) geschaltet ist.

**4.** Verstärkerschaltung nach einem der vorstehenden Ansprüche, **dadurch gekennzeichnet, dass** der Spannungsteiler (R1T3) mindestens einen Transistor (T3) umfasst.

**5.** Verstärkerschaltung nach einem der vorstehenden Ansprüche, **dadurch gekennzeichnet, dass** die Polarisationszelle (200) mehrere Transistoren (T2) in Parallelschaltung sowie mehrere Spannungsteiler (R1R2) in Parallelschaltung umfasst und **dadurch**, dass jeder der besagten Transistoren (T2) über sein Gate (G2) an einen der Spannungsteiler (R1R2) angeschlossen ist.

**6.** Verstärkerschaltung nach einem der vorstehenden Ansprüche, **dadurch gekennzeichnet, dass** diese mindestens einen Widerstand (R5) umfasst, der mit der Polarisationszelle (200) parallel geschaltet ist.

**7.** Verstärkerschaltung nach einem der vorstehenden Ansprüche, **dadurch gekennzeichnet, dass** diese mindestens einen Widerstand (R6) umfasst, der mit der Polarisationszelle (200) in Reihe geschaltet ist.

**8.** Verstärkerschaltung nach einem der vorstehenden Ansprüche, **dadurch gekennzeichnet, dass** diese eine Induktivität (L7) und einen Widerstand (R7) in Parallelschaltung umfasst, die mit der Polarisationszelle (200) in Reihe geschaltet sind.

**9.** Verstärkerschaltung nach einem der vorstehenden Ansprüche, **dadurch gekennzeichnet, dass** diese mindestens einen Widerstand (R8) und einen Kondensator (C8) in Reihenschaltung umfasst, welche zwischen dem Drain (D2) des Transistors (T2) und der Masse angeschlossen sind.

## FIG.1

## FIG.2

## FIG.3

FIG.4

FIG.5

EP 1 388 935 B1

FIG.6

FIG.7

**FIG.8**

**FIG.9**

FIG.10

FIG.11

## FIG.12

**EP 1 388 935 B1**

## RÉFÉRENCES CITÉES DANS LA DESCRIPTION

**Documents brevets cités dans la description**

- US 5880640 A